(19) Europäisches Patentamt / European Patent Office / Office européen des brevets

(11) **EP 3 648 283 B1**

(12) **EUROPEAN PATENT SPECIFICATION**

(45) Date of publication and mention
of the grant of the patent:
**07.04.2021 Bulletin 2021/14**

(51) Int Cl.:
*G06Q 50/06* (2012.01)  *G06F 30/20* (2020.01)
*G06Q 10/04* (2012.01)  *H02J 3/00* (2006.01)
*H02J 3/38* (2006.01)

(21) Application number: **18203466.0**

(22) Date of filing: **30.10.2018**

(54) **METHOD FOR FORECASTING THE ELECTRIC POWER PRODUCTION OF A RENEWABLE ENERGY POWER GENERATION PLANT**

VERFAHREN ZUR PROGNOSE DER STROMERZEUGUNG EINER ERNEUERBAREN ENERGIEERZEUGUNGSANLAGE

PROCEDE DE PREVISION DE LA PRODUCTION D'ELECTRICITE D'UNE CENTRALE DE GENERATION D'ENERGIE RENOUVELABLE

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(43) Date of publication of application:
**06.05.2020 Bulletin 2020/19**

(73) Proprietor: **MARICI Holdings The Netherlands B.V. 3068AX Rotterdam (NL)**

(72) Inventors:
• **Mazziotti, Francesca**
  **I-52025 Montevarchi (AR) (IT)**
• **Bianchi, Lorenzo**
  **I-52027 San Giovanni Valdarno (AR) (IT)**

(74) Representative: **De Bortoli, Eros et al**
**Zanoli & Giavarini S.p.A.**
**Via Melchiorre Gioia, 64**
**20125 Milano (IT)**

(56) References cited:
**WO-A1-2013/106941**   **US-A1- 2010 204 844**
**US-A1- 2013 046 492**   **US-B1- 9 638 831**

• **ALEXIADIS M C ET AL: "Wind Speed and Power Forecasting based on Spatial Correlation Models", IEEE TRANSACTIONS ON ENERGY CONVERSION, IEEE SERVICE CENTER, PISCATAWAY, NJ, US, vol. 14, no. 3, 1 September 1999 (1999-09-01), pages 836-842, XP011084512, ISSN: 0885-8969, DOI: 10.1109/60.790962**

**Description**

The present invention relates to a method for forecasting the electric power production of a renewable energy power generation plant.

As is known, a critical aspect in the management activity of a renewable energy power generation plant, e.g. a photovoltaic power generation plant, consists in forecasting the future electric power production that can be provided by such a plant.

Predicting the electric power production of a renewable energy power generation plant is generally important as it allows optimizing the performances of the power generation plant and obtaining a satisfactory return of investments.

However, such a forecasting activity is a hard task to carry out as it is influenced by a number of heterogeneous external factors including, for example, installation conditions of the power generation plant, on-the-site meteorological and environmental conditions, geographical position of the plant site, and the like.

Available prior art provides a number of methods for forecasting the electric power production of a renewable energy power generation plant. Examples of these methods can be found in US8295989B1, US8165812B1, EP1660917B1 and WO301130015851A1. US 2013/046492 A1 discloses a forecasting method involving collecting power data indicative of the power output from a set of wind energy installations (102,104,106) comprising a first wind energy installation at a first site and a second wind energy installation at a second site. The available power output at the forecasting site located at a geographic position is estimated based on the power data from the set of wind energy installations by projecting the power data towards at least one of the future and the geographic position of the forecasting site.

Although these known solutions often perform in a rather satisfying way, there is still need for further improvements capable of providing a more effective and accurate performance in forecasting the electric power production of a renewable energy power generation plant.

In order to respond to this need, the present invention provides a method for forecasting the electric power production of a renewable energy power generation plant, according to the following claim 1 and the related dependent claims.

In a general definition, the method of the invention is directed to forecast the electric power production of a renewable energy power generation plant (preferably of the photovoltaic type), in which there are installed one or more first power generation devices (preferably of the photovoltaic type) capable of generating electric power by exploiting a renewable energy source.

The method comprises the following steps:

- selecting a reference instant and an observation time period including instants preceding said reference instant;
- acquiring first data indicative of the electric power production of said first power generation device during said observation period;
- acquiring second data indicative of the electric power production of one or more second power generation devices during said observation period. Said second power generation devices are capable of generating electric power by exploiting a renewable energy source and are installed in one or more renewable energy power generation plants different from said renewable energy power generation plant;
- for each first power generation device, calculating a first observation value indicative of the electric power production of said first power generation device at said observation time period. Said first observation value is calculated basing on said first data;
- for each first power generation device, calculating a second observation value indicative of the electric power production of a family of power generation devices during said observation time period. Said family of power generation devices includes said first power generation device and one or more second power generation devices (preferably of the photovoltaic type) similar to said first power generation device. Said second observation value is calculated basing on said first observation value and said second data;
- for each first power generation device, calculating a first expected electric power production value indicative of the expected electric power production of said first power generation device at a future instant following said reference instant. Said first expected electric power production value is calculated on the base of said second observation value;
- calculating a second expected electric power production value indicative of the expected electric power production of said power generation plant at said future instant. Said second expected electric power production value is calculated basing on the first expected electric power production values calculated for the first power generation devices installed in said renewable energy power plant.

Preferably, the first observation value is calculated basing on first modeling data obtained by modeling the operating behavior of said first power generation device through a corresponding mathematical model describing the operating behavior of said first power generation device.

Preferably, the second observation value is calculated basing on one or more third observation values indicative of the electric power production of selected second power generation devices (which belong to the family of power generation devices including said first power generation device) during said observation time period. Each third observation value is calculated basing on said second data.

Preferably, the second observation value is calculated basing on second modeling data obtained by modeling the operating behavior of said first power generation device and of each second power generation device included in said family of power generation devices through corresponding mathematical models describing the operating behavior of said first and second power generation devices.

Preferably, the method of the invention comprises a step of acquiring third data indicative of the installation conditions of said first power generation devices.

Preferably, said step of calculating said first expected electric power production value comprises calculating a first correction factor to correct said second observation value. Said first correction factor is indicative of the influence of the installation conditions of said first power generation device on the electric power production of said first power generation device.

Preferably, said first correction factor is calculated basing on installation parameters included in said third data and selected for said first power generation device and basing on third modeling data obtained by modeling the operating behavior of said first power generation device using a corresponding mathematical model describing the operating behavior of said first power generation device.

Preferably, the method of the invention comprises a step of acquiring fourth data indicative of geographical position of said first power generation devices and said second power generation devices.

Preferably, said step of calculating said first expected electric power production value comprises calculating a normalization factor for said second observation value.

The calculation of said normalization factor preferably comprises:

- calculating a similarity coefficient indicative of the similarity between the operating behavior of said first power generation device and the operating behavior of a selected second power generation device belonging to the family of power generation devices including said first power generation device. Said similarity coefficient is calculated basing on the first observation value calculated for said first power generation device and the third observation value calculated for said selected second power generation device;
- calculating a geolocation coefficient indicative of the difference between the geographical position of said first power generation device and the geographical position of said selected second power generation device. Said geolocation coefficient is calculated basing on said fourth data.

Preferably, the method of the invention comprises a step of acquiring fifth data indicative of meteorological conditions at said renewable energy power generation plant at one or more instants of said observation period.

Preferably, the method of the invention comprises a step of calculating a confidence index indicative of the level of accuracy of the calculation of said second expected electric power production value. Said confidence index is calculated basing on said fifth data.

Preferably, the calculation of said confidence index comprises:

- selecting an optimal instant included in said observation period in which meteorological conditions at said power generation plant were optimal;
- calculating an optimal electric power production value indicative of the electric power production of said power generation plant at said optimal instant;
- calculating one or more past electric production values at one or more instants included in said observation period and different from said optimal instant;
- comparing each past electric production value with said optimal electric power production value;
- calculating one or more differential indexes indicative of a difference between said past electric production values and said optimal electric power production value;
- calculating said confidence index basing on said differential indexes.

Preferably, the method of the invention comprises a step of acquiring sixth data indicative of one or more physical quantities measured in said renewable energy power generation plant at said reference instant.

Preferably, the method of the invention comprises a step of calculating a third expected electric power production value indicative of the expected electric power production of said power generation plant at said future instant. Said third expected electric power production value is calculated basing on said second expected electric power production value and said sixth data.

Preferably, the step of calculating said third expected electric power production value comprises calculating a second correction factor to correct said second expected electric power production value basing on said sixth data.

In a further aspect, the present invention relates to a computerised system comprising data processing resources configured to execute the method of the invention.

Characteristics and advantages of the invention will become more apparent from the description of some preferred but not exclusive embodiments according to the present invention, illustrated only by way of non-limiting examples with the aid of the accompanying drawings, wherein:

- figure 1 schematically illustrates a renewable energy electric power generation plant;
- figures 2-6 schematically illustrate the method according to the invention.

Referring to the cited figures, the present invention is related to a method 100 for forecasting the electric power production of a renewable energy power generation plant I.

For the sake of clarity, it is specified that the term "electric power production" refers to the output power provided by the renewable energy power generation plant I in operation.

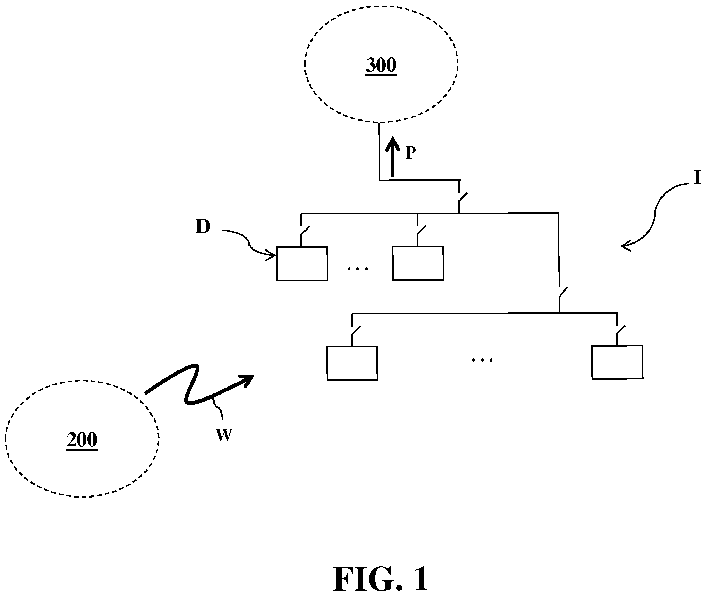

In figure 1, a schematic illustration of a renewable energy power generation plant I is shown.

The power generation plant I is adapted to receive energy W from an inexhaustible (on human timescale) natural source of energy 200, e.g. solar light, wind, water and the like, and exploit such a renewable energy to feed an electric load 300, e.g. an electric power distribution grid, with output electric power P.

Conveniently, the power generation plant I comprises one or more first power generation devices D capable of generating electric power by exploiting an amount of energy W received from the renewable energy source 200.

In general, the power generation plant I and the first power generation devices D may be of any known type (e.g. of photovoltaic type) and their structure and functioning may be readily available to a skilled person. They will not be hereinafter described in further details for the sake of brevity.

Preferably, the power generation plant I is a photovoltaic power generation plant. In this case, each first power generation device D may comprise, for example, an assembly formed by a photovoltaic string and a photovoltaic inverter, which may be of known type.

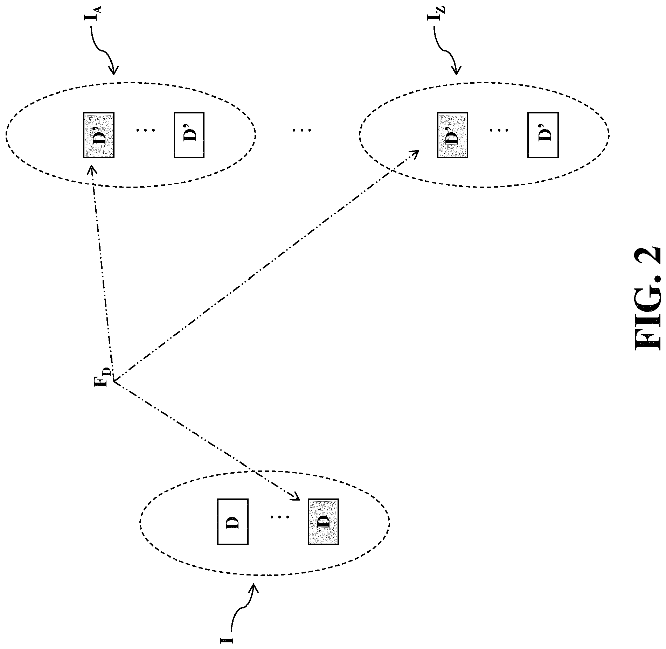

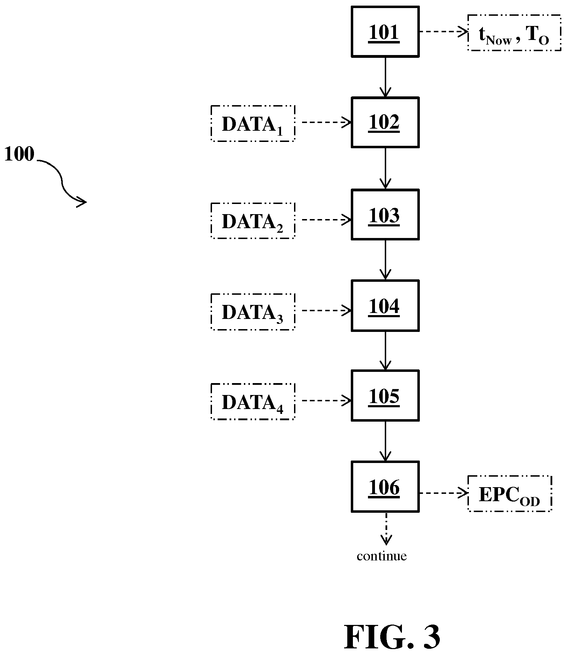

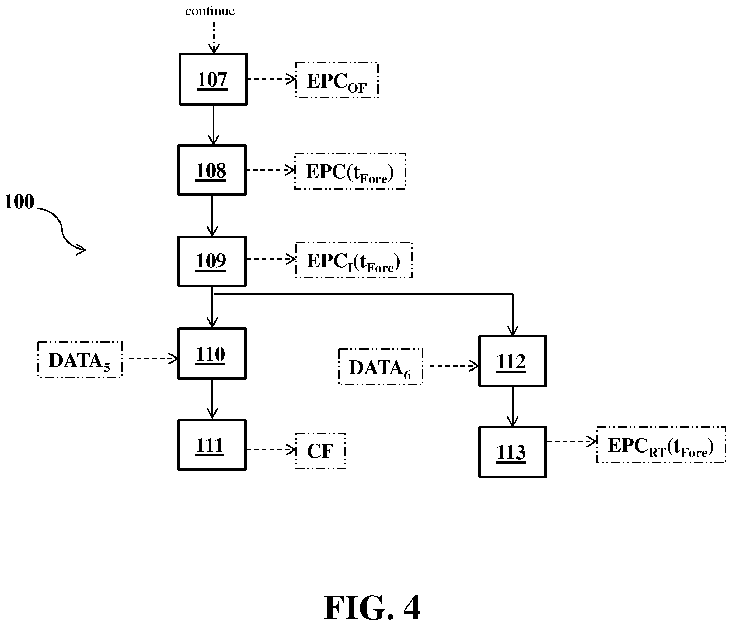

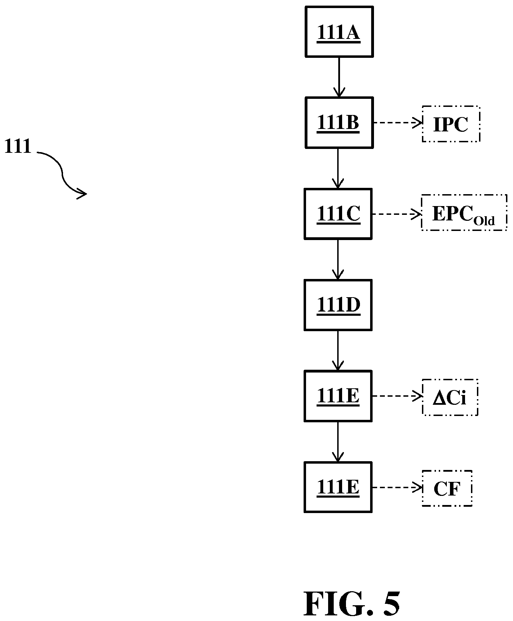

The method 100 is described hereinafter with reference to figures 2-6.

In general terms, the method 100 is addressed to forecast the electric power production of the power generation plant I at a future instant $t_{Fore}$ with respect to a reference instant $t_{Now}$ by suitably processing data referred to an observation period $T_O$, which includes time instants preceding the reference instant $t_{Now}$.

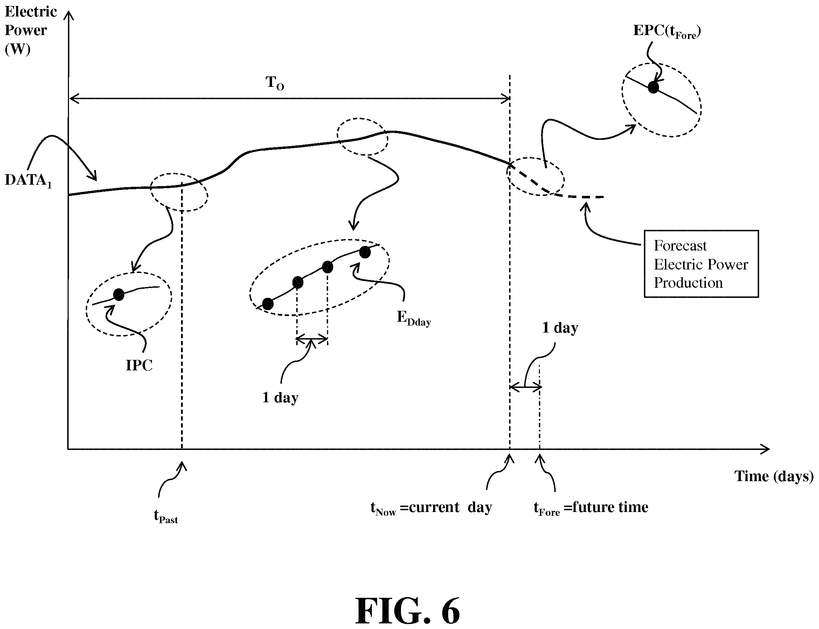

The time references $t_{Fore}$, $t_{Now}$, $t_{Past}$, $T_O$ adopted in the method 100 have a given time granularity selectable according to the needs, e.g. the time granularity of one day (as shown in figure 6), one hour or even one sampling period (e.g. in the order of ms in real time implementations). The selected time instants $t_{Fore}$, $t_{Now}$, $t_{Past}$ may thus be selected days, hours or sampling periods.

According to the invention, the method 100 comprises a step 101 of selecting a reference instant $t_{Now}$ and an observation time period $T_O$.

Conveniently, the reference instant $t_{Now}$ refers to an on-going condition of the power generation plant I. For example, it may be the current day, the current hour or the current sampling period depending on the time granularity chosen for the method 100.

The observation time period $T_O$ consists of a time interval (not necessarily continuous) including time instants preceding the reference instant $t_{Now}$. As an example, the observation time period $T_O$ may include a number of days, hours or sampling periods (not necessarily consecutives) preceding the current day, hour or sampling period (taken as reference instant $t_{Now}$) depending on the time granularity chosen for the method 100.

The method 100 comprises a step 102 of acquiring first data $DATA_1$ indicative of the electric power production of the first power generation devices D during the observation period $T_O$.

Preferably, the first data $DATA_1$ comprise (for each first power generation device D) measured first electric power production values $E_{Dday}$ provided by said first power generation device during the observation period $T_O$, e.g. at each day of the observation period $T_O$ (figure 6).

In other words, as it is schematically shown in figure 6, the first data $DATA_1$ preferably include the measured electric power production curves of the first power generation devices D during the observation period $T_O$.

An important aspect of the method 100 consists in that it exploits available historical data related to the electric power production of second power generation devices D', which are not installed in the power generation plant I, to forecast the electric power production of the power generation plant I.

As the first power generation devices D, the second power generation devices D' are capable of generating electric power by exploiting the energy W received from the renewable energy source 200. However, the second power generation devices D' are installed in renewable energy power generation plants $I_A$, ..., $I_Z$ different from the power generation plant I (figure 2).

The power generation plants $I_A$, ..., $I_Z$ may be of any known type (e.g. of photovoltaic type) and they may be readily available to a skilled person. They will not be hereinafter described in further details for the sake of brevity.

Obviously, the power generation plants I, $I_A$, ..., $I_Z$ are all of the same type, e.g. photovoltaic power generation plants.

The second power generation devices D' may be of any known type (e.g. of photovoltaic type) and they may be readily available to a skilled person. They will not be hereinafter described in further details for the sake of brevity.

As an example, if the power generation plants I, $I_A$, ..., $I_Z$ are of photovoltaic type, each power generation device D' may comprise, for example, an assembly formed by a photovoltaic string and a photovoltaic inverter, which may be of known type.

According to the invention, the method 100 comprises a step 103 of acquiring second data $DATA_2$ indicative of the electric power production of one or more second power generation devices D' during the observation period $T_O$.

Preferably, the second data $DATA_2$ comprise (for each second power generation device D') measured second electric power production values $E_{D'day}$ provided by said second power generation device during the observation period $T_O$, e.g. at each day included in the observation period $T_O$.

In other words, the second data $DATA_2$ preferably include the measured electric power production curves of the second power generation devices D' during the observation period To.

Preferably, the method 100 comprises a step 104 of acquiring third data $DATA_3$ indicative of the installation conditions of the first power generation devices D.

Preferably, the third data $DATA_3$ comprise, for each first power generation device D, installation values indicative of the specific installation conditions of said first power generation device, e.g. the device age, parameters indicative of the wear level, coefficients indicative of sub-optimal environmental conditions during operation, coefficients indicative of possible degradation, and the like.

Preferably, the method 100 comprises a step 105 of acquiring fourth data $DATA_4$ indicative of the geographical position of the first and second power generation devices D and D'.

Preferably, the fourth data $DATA_4$ comprise geo-location values indicative of the position and orography of the first power generation devices D and the second power generation devices D'. According to the invention, the method 100 comprises a step 106 of calculating a first observation value $EPC_{OD}$ for each first power generation device D.

The first observation value $EPC_{OD}$ is indicative of the electric power production (e.g. the average electric power production level) of the first power generation device D during the observation period $T_O$.

In general terms, the first observation value $EPC_{OD}$ may be expressed according to the following relation:

$$EPC_{OD} = f_1(DATA_1)$$

For each first power generation device D, the first observation value $EPC_{OD}$ is, in fact, conveniently calculated basing on the first data $DATA_1$, more particularly by suitably processing the measured first electric power production values $E_{Dday}$ provided by said first power generation device during the observation period $T_O$.

Preferably, the first observation value $EPC_{OD}$ is also calculated basing on first modeling data obtained by modeling the operating behavior of the first power generation device D through a corresponding mathematical model $M_D$ (e.g. a suitable set of equations) describing the physical and functional behavior of said first power generation device.

As an example, the first observation value $EPC_{OD}$ related to a given first power generation device D may be calculated as follows:

$$EPC_{OD} = K1 \sum_{i=1}^{R} \left(\frac{1}{Y} \sum_{j=1}^{Y} E_{Dday,i,j}\right)$$

where $E_{Dday,i,j}$ is a first electric power production value (which is included in the first data $DATA_1$) of the first power generation device D on the i-th day in the j-th year of the observation period $T_O$, Y is the number of overall number of years included in the observation time period $T_O$, R is the overall number of first electric power production values $E_{Dday}$ selected from the first data $DATA_1$ and K1 is a modeling parameter (e.g. K1<1) calculated by modeling the operating behavior of the first power generation device D through a corresponding mathematical model $M_D$.

According to the invention, the method 100 comprises a step 107 of calculating a second observation value $EPC_{OF}$ for each first power generation device D.

The second observation value $EPC_{OF}$ is indicative of the electric power production (e.g. the average electric power production level) of a family $F_D$ of power generation devices during the observation time period $T_O$.

The above-mentioned family $F_D$ of power generation devices includes the first power generation device D and one or more second power generation devices D' similar to the first power generation device D.

For the sake of clarity, it is specified that a second power generation device D' is considered as "similar" to a given first power generation device D, if said second power generation device has a same structure and functioning of the first power generation device D.

For example, a second power generation device D' is considered "similar" to a given first power generation device D, if said second power generation device has a nominal production curve overlapping (within a predefined overlapping range) with the nominal production curve of the first power generation device D.

In figure 2, it is schematically shown an example of family $F_D$ of power generation devices for a first power generation device D installed in the power generation plant. In this exemplary case, the family $F_D$ includes the first power generation device D and a pair of second power generation devices D' installed in the power generation plants $I_A$ and $I_Z$, which are similar to the first power generation device D.

For each first power generation device D, a corresponding family $F_D$ of power generation devices may be selected according to suitable selection criteria that depend on the structure and functioning of the power generation plant I.

Each family $F_D$ of power generation devices may be predefined before the execution of the method 100 or even defined run-time, during each execution cycle of the method 100.

In general terms, for each first power generation device D, the second observation value $EPC_{OF}$ may be expressed according to the following relation:

$$EPC_{OF} = f_2(EPC_{OD}, DATA_2)$$

For each first power generation device D, the second observation value $EPC_{OF}$ is, in fact, calculated basing on the first observation value $EPC_{OD}$ calculated for said first power generation device and the second data $DATA_2$.

Preferably, the second observation value $EPC_{OF}$ is calculated basing on the first observation value $EPC_{OD}$ calculated for the first power generation device D and one or more third observation values $EPC_{OD'}$ calculated for the second power generation devices D' included in the corresponding family $F_D$ of power generation devices, which includes the first power generation device D.

Each third observation value $EPC_{OD'}$ is indicative of the average electric power production of a second power generation devices D' belonging to the family $F_D$ of power generation devices during said observation time period $T_O$.

Each third observation value $EPC_{O,D'}$ is calculated basing on the second data $DATA_2$, more particularly by suitably processing the measured second electric power production values $E_{D'day}$ provided by the second power generation devices D', which are included in the family $F_D$ of power generation devices, during the observation period $T_O$.

Conveniently, the third observation value $EPC_{OD'}$ related to each second power generation device D' may be calculated similarly to the first observation value $EPC_{OD}$ related to a given first power generation device D.

Preferably, the second observation value $EPC_{OF}$ is calculated also basing on second modeling data obtained by modeling the operating behavior of the first power generation device D and the second power generation devices D' included in the family $F_D$ through corresponding mathematical models $M_D$, $M_{D'}$ (e.g. a suitable sets of equations) describing the physical and functional behavior of said first and second power generation devices.

As an example, for each first power generation device D, the second observation value $EPC_{OF}$ may be calculated as follows:

$$EPC_{OF} = K2 \left( EPC_{OD} + \sum_{i=1}^{S} EPC_{COD'i} \right)$$

where $EPC_{OD}$ is the first observation value calculated for the first power generation device D, $EPC_{OD'i}$ is the third observation value calculated for the i-th second power generation device D' included in the family $F_D$ of power generation devices together with the first power generation device D, S is the overall number of second power generation devices included in the family $F_D$ of power generation devices and K2 is a modeling parameter (e.g. K2<1) calculated by modeling the operating behavior of the first and second power generation devices D, D' through corresponding mathematical models $M_D$, $M_{D'}$.

According to the invention, the method 100 comprises the step 108 of calculating a first expected electric power production value EPC for each first power generation device D.

The first expected electric power production value $EPC(t_{Fore})$ is indicative of the expected electric power production of the first power generation device D at a future instant $t_{Fore}$ following the reference instant $t_{Now}$.

As an example, the first expected electric power production value $EPC(t_{Fore})$ may be indicative of the expected electric power production of the first power generation device D at the day $t_{Fore}$ subsequent the current day $t_{Now}$, as schematically shown in figure 6.

For each first power generation device D, the first expected electric power production value EPC is calculated basing on the corresponding second observation value $EPC_{OF}$ calculated for said power generation device.

According to some embodiments of the invention, for each first power generation device D, the first expected electric power production value $EPC(t_{Fore})$ is calculated by correcting the corresponding second observation value $EPC_{OF}$ with one or more correction factors calculated basing on the above-mentioned third and fourth data $DATA_3$, $DATA_4$ and third modeling data obtained by modeling the operating behavior of the first power generation device D through corresponding mathematical models $M_D$ (e.g. a suitable sets of equations) describing the physical and functional behavior of said first power generation devices.

Preferably, the step 108 of calculating a first expected electric power production value $EPC(t_{Fore})$ comprises calculating of a first correction factor $L_D$ to correct the second observation value $EPC_F$.

The first correction factor $L_D$ is indicative of the influence of the installation conditions of the first power generation device D on the electric power production of said first power generation device.

As an example, the first correction factor $L_D$ may indicate whether the first power generation device D is installed in sub-optimal conditions, so that a reduction of the electric power production of said first power generation devices has to be expected because of these sub-optimal installation conditions.

Preferably, for each power generation device D, the first correction factor $L_D$ is calculated basing on installation parameters included in the third data $DATA_3$ and basing on third modeling data obtained by modeling the operating behavior of the first power generation device D using a corresponding mathematical model $M_D$ describing the operating behavior of said first power generation device.

As an example, for each first power generation device D, the first correction factor $L_D$ may be calculated as follows:

$$L_D = \frac{1}{a * D_y + 1}$$

where Dy is a an installation parameter (e.g. the operating age) selected (from the third data $DATA_3$) for the first power generation device 3 and *a* is a derating coefficient obtained by modeling the operating behavior of the first power generation device D using a corresponding mathematical model $M_D$.

Preferably, the step 108 of calculating a first expected electric power production value EPC comprises the calculation of a normalization factor $N_D$ for the second observation value $EPC_F$.

The normalization factor $N_D$ is conveniently used to normalize the prediction of the electric power production of the first power generation device D taking as a reference at least a second power generation device D' included in the family $F_D$ to which the first power generation device D belongs.

As an example, the normalization factor $N_D$ may be indicative of how the prediction of the electric power production should be corrected in view of a similarity level between the first power generation device D and a reference second power generation device D' included in the family $F_D$ to which the first power generation device D belongs.

Preferably, for each first power generation device D, the calculation of the normalization factor $N_D$ comprises calculating a similarity coefficient $S_D$ indicative of the similarity between the operating behavior of the first power generation device D and the operating behavior of a selected second power generation device D' belonging to the family F of power generation devices to which the first power generation device D belongs (the selected second power generation device D' is selected to be taken as a reference).

Conveniently, the similarity coefficient $S_D$ is calculated basing on the first observation value $EPC_{OD}$ calculated for the first power generation device D and basing on the third observation value $EPC_{OD'}$ calculated for the selected second power generation device D'.

As an example, for each first power generation device D, the similarity coefficient $S_D$ may be calculated as follows:

$$S_D = 1 - \left| \frac{EPC_{OD} - EPC_{OD'}}{EPC_{OD}} \right|$$

where $EPC_{OD}$ is the first observation value calculated for the first power generation device D and $EPC_{OD'}$ is the third observation value calculated for the selected second power generation device D' included in the same family $F_D$ of the first power generation device D.

Preferably, for each first power generation device D, the calculation of the normalization factor $N_D$ comprises calculating a geolocation coefficient $G_D$ indicative of the difference between the geographical position of the first power generation device D and the geographical position of the selected second power generation device D' included in the same family $F_D$ of the first power generation device D.

Preferably, the geolocation coefficient $G_D$ is calculated basing on the above-mentioned fourth data $DATA_4$.

As an example, for each first power generation device D, the geolocation coefficient $G_D$ may be calculated as follows:

$$G_D = \left| \frac{C_D - C_{D'}}{C_D} \right|$$

where $C_D$ and $C_{D'}$ are respectively the geolocation coordinates of the first power generation device D and the geolocation coordinates of the selected second power generation device D' included in the same family $F_D$ of the first power generation device D. The geolocation coordinates $C_D$, $C_{D'}$ are included in the fourth data $DATA_4$,

Preferably, for each first power generation device D, the calculation of the normalization factor $N_D$ is based on the above-calculated similarity coefficient $S_D$ and geolocation coefficient $G_D$.

As an example, for each first power generation device D, the normalization factor $N_D$ may be calculated as follows:

$$N_D = (1 - G_D) * S_D$$

where $S_D$, $G_D$ are respectively the above-mentioned similarity coefficient and the geolocation coefficient calculated for the first power generation device D.

In general terms, the first expected electric power production value $EPC(t_{Fore})$ may be expressed according to the following relation:

$$EPC(t_{Fore}) = f_3(EPC_{OF}, L_D, N_D)$$

For each first power generation device D, the expected electric power production value EPC may be conveniently calculated basing on the second observation value $EPC_{OF}$, the first correction factor $L_D$ and the normalization factor $N_D$ calculated for said power generation device.

As an example, for each first power generation device D, the first expected electric power production value EPC may be calculated as follows:

$$EPC(t_{Fore}) = \frac{L_D}{N_D} * EPC_{OF}$$

where $EPC_{OF}$, $L_D$, $N_D$ are respectively the second observation value, the first correction factor and the normalization factor $N_D$ calculated for the first power generation device D.

According to the invention, the method 100 comprises a step 109 of calculating a second expected electric power production value $EPC_I$ indicative of the expected electric power production of the overall power generation plant I at the future instant $t_{Fore}$.

The second expected electric power production value $EPC_I(t_{Fore})$ is conveniently calculated basing on the first expected electric power production values $EPC(t_{Fore})$ calculated for all the first power generation devices D installed in said renewable energy power plant I.

As an example, the second expected electric power production value $EPC_I(t_{Fore})$ may be calculated as follows:

$$EPC_I(t_{Fore}) = \sum_{i=1}^{N} EPC(t_{Fore})_i$$

where $EPC(t_{Fore})_i$ is the first expected electric power production value calculated for the i-th first power generation device D installed in the power generation plant I and N is the overall number of first power generation devices D included in the power generation plant I.

According to preferred embodiments of the invention, the method 100 provides for calculating a confidence index CF indicative of the level of accuracy of the calculation of the second expected electric power production value $EPC_I(t_{Fore})$.

In practice, the confidence index CF provides information on the actual level of accuracy of the results obtained by executing the previous steps 106-109 of the method 100.

Conveniently, such the confidence index CF is calculated basing on historical meteorological data related to the power generation plant I.

The method 100 of the invention thus preferably comprises the step 110 of acquiring fifth data $DATA_5$ indicative of meteorological conditions at the power generation plant I during the observation period $T_O$.

The fifth data $DATA_5$ conveniently include information concerning the meteorological condition at the power generation plant I during the observation period $T_O$ (e.g. on one or more days).

Preferably, the method 100 comprises the step 111 of calculating the confidence index CF basing on the fifth data $DATA_5$.

Preferably, the calculation of confidence index CF comprises the step 111A of selecting an optimal instant (e.g. an optimal past day) included in the observation period $T_O$ in which meteorological conditions at the power generation plant I (as reported in the fifth data $DATA_5$) were optimal.

Preferably, the calculation of confidence index CF comprises the step 111B of calculating an optimal electric power production value IPC indicative of the electric power production provided by said power generation plant I at the selected instant $t_{Past}$.

In general terms, the optimal electric power production value IPC may be expressed according to the following relation:

$$IPC = f_4(DATA_1)$$

The optimal electric power production value IPC may be calculated basing on the measured first electric power production value $E_{Dday}$ provided by each first power generation devices D of the power generation plant I at the optimal instant $t_{Past}$.

As an example, the optimal electric power production value IPC may be calculated as follows:

$$IPC = \sum_{i=1}^{N} E_{Dday_i}$$

where $E_{Dday i}$ is the electric power production value provided by the i-th first power generation device D of the power generation plant I at the optimal instant $t_{Past}$ and N is the overall number of first power generation devices D included in the power generation plant I. The electric power production value $E_{Dday i}$ is included in the first data $DATA_1$.

Preferably, the calculation of confidence index CF comprises the step 111C of calculating a past electric power production value $EPC_{Old}$ indicative of the electric power production provided by said power generation plant I at one or more selected instants (e.g. one or more selected days) of the observation period $T_O$, which are different from the optimal instant $t_{Past}$.

The past electric power production value $EPC_{Old}$ may be calculated similarly to the optimal electric power production value IPC.

As an example, for each selected instant different from the optimal past instant $t_{Past}$, the past electric power production value $EPC_{Old}$ may be calculated as follows:

$$EPC_{Old} = \sum_{i=1}^{N} E_{Dday_i}$$

where $E_{Dday i}$ is the electric power production value provided by the i-th first power generation device D of the power generation plant I at the selected instant different from the optimal instant $t_{Past}$ and N is the overall number of first power generation devices D included in the power generation plant I. The electric power production value $E_{Dday i}$ is included in the first data $DATA_1$.

Preferably, the calculation of confidence index CF comprises the step 111D of comparing each past electric production value $EPC_{Old}$ with the optimal electric power production value IPC.

Preferably, the calculation of confidence index CF comprises the step 111E of calculating a differential index $\Delta Ci$ indicative of the difference between each past electric production value $EPC_{Old}$ and the optimal electric power production value IPC.

Preferably, the calculation of the differential index $\Delta Ci$ related to each past electric production value $EPC_{Old}$ is based on the above-mentioned comparison between each past electric production value $EPC_{Old}$ and the calculated optimal electric power production value IPC.

As an example, the differential index $\Delta Ci$ related to the i-th past electric production value $EPC_{Old}$ may be calculated as follows:

$$\Delta C_i = (EPC_{Oldi} - IPC)$$

where $EPC_{Oldi}$ is the i-th past electric production value at the i-th instant of the observation period $T_O$, which is different from the optimal instant $t_{Past}$ and IPC is the optimal electric power production value as calculated above.

Preferably, the calculation of confidence index CF comprises the step 111F of calculating said confidence index basing on the calculated differential indexes $\Delta Ci$.

As an example, the optimal electric power production value IPC may be calculated as follows:

$$CF = \sum_{i=1}^{Q} \alpha_i \Delta C_i$$

where $\alpha i$ is a coefficient calculated for the i-th differential index $\Delta C_i$ and Q is the overall number of selected instants of the observation period $T_O$, which are different from the optimal instant $t_{Past}$.

According to preferred embodiments of the invention, the method 100 provides for calculating a third expected electric power production value $EPC_{RT}(t_{Fore})$ indicative of the expected electric power production of the power generation plant I at the future instant $t_{Fore}$.

An important aspect of these embodiments of the invention consists in that the third expected electric power production value $EPC_{RT}(t_{Fore})$ is calculated by correcting the second expected electric power production value $EPC_I$ calculated at the previous step 110 basing on real-time measurements of physical quantities detected in the power generation plant I at the reference instant $t_{Now}$.

Therefore, it can be obtained a refinement of the prediction value $EPC_I(t_{Fore})$, which takes into account the real-time measurements related to the actual operation of the power generation plant I.

For the sake of clarity, it is specified that the term "real-time" refers to an on-going operating status of the power generation plant I at the reference instant $t_{ow}$.

The method 100 of the invention thus preferably comprises the step 112 of acquiring sixth data $DATA_6$ indicative of one or more physical quantities measured in the renewable energy power generation plant I at the reference instant $t_{now}$.

The sixth data $DATA_6$ conveniently include real-time detection information provided by suitable sensors installed in the power generation plant I, e.g. voltage sensors, current sensors, temperatures sensors, sensors specifically dedicated to the type of the power generation plant (such as solar irradiation sensors, wind speed sensors, pressure sensors, etc.) and the like.

In general terms, the third expected electric power production value $EPC_{RT}(t_{Fore})$ may be expressed according to the following relation:

$$EPC_{RT}(t_{Fore}) = f_5(EPC_I(t_{Fore}), DATA_6)$$

In fact, the method 100 preferably comprises the step 113 of calculating the third expected electric power production value $EPC_{RT}(t_{Fore})$ at the future instant $t_{Fore}$ basing on the second expected electric power production value $EPC_I(t_{Fore})$ and the sixth data $DATA_6$.

Preferably, the step 113 of calculating the third expected electric power production value $EPC_{RT}(t_{Fore})$ comprises calculating a second correction factor $R_T$ basing on the sixth data $DATA_6$.

The second correction factor RT is conveniently used to correct the second expected electric power production value $EPC_I(t_{Fore})$, thereby providing a refinement of the prediction value $EPC_I(t_{Fore})$, which takes into account the real-time measurements related to the actual operation of the power generation plant I.

In general, the calculation of the correction factor RT depends on the type of the power generation plant I and on the type of measurements provided by the sensors installed on the field.

An example of calculation of the correction factor RT is provided in the following.

It is assumed that the power generation plant I is a photovoltaic power generation plant and that the sixth data $DATA_6$ include first measurement values $I_S$ indicative of the solar irradiation received by the power generation plant I, second measurement values $T_M$ indicative of the temperature at the power generation plant I, third measurement values $P_T$ indicative of the nominal electric power production of the power generation plant I (at suitable standard test conditions) and fourth measurement values $E_M(t_{Now})$ indicative of the actual electric power production of the power generation plant I at the reference instant $t_{Now}$. Based on the above-mentioned first, second and third measurement values, it is conveniently calculated an expected electric power production value $E_S(t_{Now})$ indicative of the expected electric power production of the power generation plant I at the reference instant $t_{Now}$.

To this aim, known standard equations (e.g. those provided by known international institutions like the NREL - National Renewable Energy Laboratory) may be used.

As an example, the expected electric power production value $E_S(t_{Now})$ may be calculated as follows:

$$E_S(t_{Now}) = (1 + (T_M - 25) * \beta/100) * P_T * I_S * \gamma$$

where $\beta$ is a temperature coefficient and y is a derating constant that takes into account possible losses of the power generation plant I.

The correction factor RT may then be calculated as follows:

$$RT = \left(1 - \frac{E_M(t_{Now}) - E_S(t_{Now})}{E_M(t_{Now})}\right)$$

where $E_M(t_{Now})$, $E_S(t_{Now})$ are respectively the measured and the expected electric power production values of the power generation plant I at the reference instant $t_{Now}$.

The third expected electric power production value $EPC_{RT}(t_{Fore})$ can then be calculated as follows:

$$EPC_{RT}(t_{Fore}) = EPC_I(t_{Fore}) * RT$$

where $EPC_I(t_{Fore})$ is the second expected electric power production value calculated for the power generation plant I.

As it may be easily understood, further examples of calculation of the second correction factor RT are possible depending on the specific typology of the power generation plant I.

However, the above-mentioned variant of the method 100 allows taking into account the actual operating conditions of the power generation plant I while predicting the expected electric power production of said plant at a future instant $t_{Fore}$.

As illustrated above, the method 100 provides predictive values $EPC_I(t_{Fore})$, $EPC_{RT}(t_{Fore})$ indicative of the electric power production of the power generation plant I at a future instant $t_{Fore}$ following the reference instant $t_{Now}$.

The method 100 may be cyclically repeated to calculate further predictive values indicative of the electric power production of the power generation plant I at subsequent future instants.

At each repetition cycle, a new reference instant $t_{Now}$ and a new observation period $T_O$ are conveniently selected. In addition, the first data $DATA_1$ and the second data DATA2 are conveniently updated with new measured first electric power production values $E_{Dday}$ and new measured second electric power production values $E_{D'day}$, which are respectively related to the operation of the first and second power generation devices D and D'. Similarly, at each repetition cycle, the fifth data $DATA_5$ and the sixth data $DATA_6$ are updated to take into account of the new selected reference instant $t_{Now}$ and observation period $T_O$.

It is evident that the frequency of the repetition cycles of the method 100 basically depends on the adopted time granularity. The method 100 may thus be repeated every day, every hour or even every sampling instant (e.g. in real-time implementations).

The method 100 may be subject to possible variants and modifications falling within the scope of the present invention.

In an exemplary variant of the method 100, a family $F_D$ of power generation devices, which includes a given first power generation device D, may include such a first power generation device only and no second power generation devices similar to said first power generation device. In this particular case, the first and second observation values $EPC_{OD}$, $EPC_{OF}$ calculated for the power generation device D will obviously coincide.

In a further exemplary variant of the method 100, depending of the completeness of the sixth data $DATA_6$, a differential index $\Delta Ci$ may be calculated with reference to a limited number of time instants different from the optimal instant $t_{Past}$ of the observation period $T_O$, e.g. with reference to a number of days (different from the optimal day $t_{Past}$) smaller than the overall number of days of the observation period $T_O$.

Additional variants of the method 100 may provide for the above-illustrated steps 101-113 of the method 100 to be executed in a different order with respect to the above-illustrated embodiments.

The method 100 for forecasting the electric power production of a renewable energy power generation plant provides several advantages with respect to the state of the art.

The method 100 suitably processes historical information related to the past electric power production of the power generation plant I to obtain prediction values related to the future electric power production of the power generation plant I.

Being substantially based on the observation of the past behavior of a power generation plant, the method 100 provides a providing an effective and accurate performance in forecasting the future electric power production.

Additionally, the method 100 suitably processes information related to objective operating conditions of a power generation plant. This allows the forecasting activity to take into account the major factors that normally have a strong and unpredictable impact, such as the installation conditions of the power generation plant, the meteorological and environmental conditions of the power generation plant and the geographical position of the power generation plant.

Finally, the method 100 provide additional refinements that allow obtaining information of accuracy of the forecasting activity and taking into account the actual operating status of the power generation plant 100 as reported by real-time measurements of suitable physical quantities.

The method 100 is of relatively easy implementation at industrial level.

As an example, it can be easily carry out by a computerised system (e.g. a cloud computerised platform or a server or a computerised unit installed on the field) comprising data processing means (e.g. one or more microcontrollers or digital signal processors) capable of executing suitable software instructions stored in a memory and configured in such a way to implement the above-illustrated steps of the method 100, when they are executed.

The method 100 can be thus be easily implemented at competitive costs with respect to traditional solutions of the state of the art.

**Claims**

1. A method (100) for forecasting the electric power production of a renewable energy power generation plant (I), said power generation plant having installed one or more first power generation devices (D) capable of generating electric power by exploiting a renewable energy source, wherein the method comprises the steps of:

    - selecting (101) a reference instant ($t_{Now}$) and an observation time period (To) including instants preceding said reference instant ($t_{Now}$);
    - acquiring (102) first data ($DATA_1$) indicative of the electric power production of said first power generation devices (D) during said observation period (To);
    - acquiring (103) second data ($DATA_2$) indicative of the electric power production of one or more second power generation devices (D') during said observation period (To), said second power generation devices (D') being capable of generating electric power by exploiting a renewable energy source and being installed in one or more renewable energy power generation plants different from said renewable energy power generation plant (I);
    - for each first power generation device (D), calculating (106) a first observation value ($EPC_{OD}$) indicative of the electric power production of said first power generation device (D) at said observation time period (To), said first observation value ($EPC_{OD}$) being calculated basing on said first data ($DATA_1$) **characterised in that** the method comprises the steps of:

        - for each first power generation device (D), calculating (107) a second observation value ($EPC_{OF}$) indicative of the electric power production of a family ($F_D$) of power generation devices, which includes said first power generation device (D) and one or more second power generation devices (D') having a same structure and functioning of said first power generation device (D), during said observation time period (To), said second observation value being calculated based on said first observation value ($EPC_{OD}$) and said second data ($DATA_2$);
        - for each first power generation device (D), calculating (108) a first expected electric power production value ($EPC(t_{Fore})$) indicative of the expected electric power production of said first power generation device

(D) at a future instant ($t_{Fore}$) following said reference instant ($t_{Now}$), said first expected electric power production value (EPC($t_{Fore}$)) being calculated based on said second observation value (EPC$_{OF}$);
- calculating (109) a second expected electric power production value (EPC$_I$($t_{Fore}$)) indicative of the expected electric power production of said power generation plant (I) at said future instant ($t_{Fore}$), said second expected electric power production value being calculated based on the first expected electric power production values (EPC($t_{Fore}$)) calculated for the first power generation devices (D) installed in said renewable energy power plant (I).

2. A method, according to claim 1, **characterised in that** said first observation value (EPC$_{OD}$) is calculated based on first modeling data ($K_1$) obtained by modeling the operating behavior of said first power generation device (D) through a corresponding mathematical model describing the operating behavior of said first power generation device.

3. A method, according to one or more of the previous claims, **characterised in that** said second observation value (EPC$_{OF}$) is calculated based on one or more third observation values (EPC$_{OD'}$) indicative of the electric power production of second power generation devices (D'), which belong to the family ($F_D$) of power generation devices including said first power generation device (D), during said observation time period (To), each third observation value (EPC$_{OD'}$) being calculated based on said second data (DATA$_2$).

4. A method, according to claim 3, **characterised in that** said second observation value (EPC$_{OD'}$) is calculated based on second modeling data ($K_2$) obtained by modeling the operating behavior of said first power generation device (D) and of each second power generation device (D') included in said family ($F_D$) of power generation devices through corresponding mathematical models describing the operating behavior of said first and second power generation devices (D, D').

5. A method, according to one or more of the previous claims, **characterised in that** it comprises a step of acquiring (104) third data (DATA$_3$) indicative of the installation conditions of said first power generation devices (D).

6. A method, according to claim 5, **characterised in that** said step (108) of calculating said first expected electric power production value (EPC($t_{Fore}$)) comprises calculating a first correction factor ($L_D$) to correct said second observation value (EPC$_{OF}$), said first correction factor being indicative of the influence of the installation conditions of said first power generation device (D) on the electric power production of said first power generation device, the calculation of said first expected electric power production value being based on said first correction factor.

7. A method, according to claim 6, **characterised in that** said first correction factor ($L_D$) is calculated based on installation parameters ($D_y$) included in said third data (DATA$_3$) and selected for said first power generation device (D) and based on third modeling data (*a*) obtained by modeling the operating behavior of said first power generation device (D) using a corresponding mathematical model describing the operating behavior of said first power generation device.

8. A method, according to one or more of the previous claims, **characterised in that** it comprises the step of acquiring (105) fourth data (DATA$_4$) indicative of geographical position of said first power generation devices (D) and said second power generation devices (D').

9. A method, according to claim 8, **characterised in that** said step (108) of calculating said first expected electric power production value (EPC($t_{Fore}$)) comprises calculating a normalization factor ($N_D$) for said second observation value (EPC$_{OF}$), the calculation of said first expected electric power production value being based on said normalization factor.

10. A method, according to claim 3 and 9, **characterised in that** said the calculation of said normalization factor ($N_D$) comprises:

    - calculating a similarity coefficient ($S_D$) indicative of the similarity between the operating behavior of said first power generation device (D) and the operating behavior of a selected second power generation device (D') belonging to the family ($F_D$) of power generation devices including said first power generation device (D), said similarity coefficient being calculated based on the first observation value (EPC$_{O,D}$) calculated for said first power generation device (D) and the third observation value (EPC$_{OD'}$) calculated for said selected second power generation device (D');
    - calculating a geolocation coefficient ($S_D$) indicative of the difference between the geographical position of said first power generation device (D) and the geographical position of said selected second power generation device (D'), said geolocation coefficient being calculated based on said fourth data ($DATA_4$);

the calculation of said normalization factor being based on said similarity coefficient and geolocation coefficient.

11. A method, according to one or more of the previous claims, **characterised in that** it comprises the step of acquiring (110) fifth data ($DATA_5$) indicative of meteorological conditions at said renewable energy power generation plant (I) at one or more instants of said observation period (To).

12. A method, according to claim 11, **characterised in that** it comprises a step (111) of calculating a confidence index (CF) indicative of the level of accuracy of the calculation of said second expected electric power production value ($EPC_I(t_{Fore})$), said confidence index being calculated based on said fifth data ($DATA_5$).

13. A method, according to claim 12, **characterised in that** said the step (111) of calculating said confidence index (CF) comprises:

- selecting (111A) an optimal instant ($t_{Past}$) included in said observation period (To) in which meteorological conditions at said power generation plant (I) were optimal;
- calculating (111B) an optimal electric power production value (IPC) indicative of the electric power production of said power generation plant (I) at said optimal instant ($t_{Past}$);
- calculating (111C) one or more past electric production values ($EPC_{Old}$) at one or more instants included in said observation period (To) and different from said optimal instant ($t_{Past}$),
- comparing (111D) each past electric production value ($EPC_{Old}$) with said optimal electric power production value (IPC);
- calculating (111E) one or more differential indexes ($\Delta Ci$) indicative of a difference between said past electric production values ($EPC_{Old}$) and said optimal electric power production value (IPC);
- calculating (111F) said confidence index (CF) basing on said differential indexes ($\Delta Ci$).

14. A method, according to one or more of the previous claims, **characterised in that** it comprises the step of acquiring (112) sixth data ($DATA_6$) indicative of one or more physical quantities measured in said renewable energy power generation plant (I) at said reference instant ($t_{now}$).

15. A method, according to claim 14, **characterised in that** it comprises a step (113) of calculating a third expected electric power production value ($EPC_{RT}(t_{Fore})$) indicative of the expected electric power production of said power generation plant (I) at said future instant ($t_{Fore}$), said third expected electric power production value being calculated based on said second expected electric power production value ($EPC_I(t_{Fore})$) and said sixth data ($DATA_6$).

16. A method, according to claim 15, **characterised in that** the step (113) of calculating said third expected electric power production value ($EPC_{RT}(t_{Fore})$) comprises calculating a second correction factor ($R_T$) to correct said second expected electric power production value based on said sixth data ($DATA_6$).

17. A method, according to one or more of the previous claims, **characterised in that** said renewable energy power generation plant (I) is a photovoltaic power generation plant.

18. A computerised system comprising data processing resources configured to execute a method (100), according to one or more of the previous claims.

**Patentansprüche**

1. Ein Verfahren (100) zur Prognose der Stromerzeugung einer Anlage (I) zur Erzeugung erneuerbarer Energie, wobei die Stromerzeugungsanlage eine oder mehrere erste Stromerzeugungseinrichtungen (D) aufweist, die in der Lage sind, Strom zu erzeugen durch Ausnutzen einer Quelle erneuerbarer Energie, wobei das Verfahren die Schritte umfasst:

- Wählen (101) eines Referenzzeitpunkts ($t_{Now}$) und einer Beobachtungszeitperiode (To) einschließlich von Zeitpunkten vor dem Referenzzeitpunkt ($t_{Now}$);
- Erfassen (102) erster Daten ($DATA_1$), die die Stromerzeugung der ersten Stromerzeugungseinrichtungen (D) während der Beobachtungsperiode (To) anzeigen;
- Erfassen (103) zweiter Daten ($DATA_2$), die die Stromerzeugung von einer oder mehreren zweiten Stromerzeugungseinrichtungen (D') während der Beobachtungsperiode (To) anzeigen, wobei die zweiten Stromerzeugungseinrichtungen (D') in der Lage sind, Strom zu erzeugen durch Ausnutzen einer Quelle erneuerbarer Energie und in einer oder mehreren Anlagen zur Erzeugung erneuerbarer Energie, die von der Anlage (I) zur Erzeugung erneuerbarer Energie verschieden sind, installiert sind;
- für jede erste Stromerzeugungseinrichtung (D), Berechnen (106) eines ersten Beobachtungswerts ($EPC_{OD}$), der die Stromerzeugung der ersten Stromerzeugungseinrichtung (D) bei der Beobachtungszeitperiode (To) anzeigt, wobei der erste Beobachtungswert ($EPC_{OD}$) auf Basis der ersten Daten ($DATA_1$) berechnet wird, **dadurch gekennzeichnet, dass** das Verfahren die Schritte umfasst:
- für jede erste Stromerzeugungseinrichtung (D), Berechnen (107) eines zweiten Beobachtungswerts ($EPC_{OF}$), der die Stromerzeugung einer Familie ($F_D$) von Stromerzeugungseinrichtungen anzeigt, die die erste Stromerzeugungseinrichtung (D) und eine oder mehrere zweite Stromerzeugungseinrichtungen (D') mit einer gleichen Struktur und Funktionsweise der ersten Stromerzeugungseinrichtung (D) enthält, während der Beobachtungszeitperiode (To), wobei der zweite Beobachtungswert berechnet wird auf Basis des ersten Beobachtungswerts ($EPC_{OD}$) und der zweiten Daten ($DATA_2$);
- für jede erste Stromerzeugungseinrichtung (D), Berechnen (108) eines ersten erwarteten Stromerzeugungswerts ($EPC(t_{Fore})$), der die erwartete Stromerzeugung der ersten Stromerzeugungseinrichtung (D) zu einem zukünftigen Zeitpunkt ($t_{Fore}$) nach dem Referenzzeitpunkt ($t_{Now}$) anzeigt, wobei der erwartete Stromerzeugungswert ($EPC(t_{Fore})$) berechnet wird auf Basis des zweiten Beobachtungswerts ($EPC_{OF}$);
- Berechnen (109) eines zweiten erwarteten Stromerzeugungswerts ($EPC_I(t_{Fore})$), der die erwartete Stromproduktion der Stromerzeugungsanlage (I) zu dem zukünftigen Zeitpunkt ($t_{Fore}$) anzeigt, wobei der zweite erwartete Stromerzeugungswert berechnet wird auf Basis der ersten erwarteten Stromerzeugungswerte ($EPC(t_{Fore})$) berechnet für die in der Anlage (I) zur Erzeugung erneuerbarer Energie installierten ersten Stromerzeugungseinrichtungen (D).

2. Verfahren nach Anspruch 1, **dadurch gekennzeichnet, dass** der erste Beobachtungswert ($EPC_{OD}$) berechnet wird auf Basis von ersten Modellierungsdaten ($K_1$) erhalten durch Modellieren des Arbeitsverhaltens der ersten Stromerzeugungseinrichtung (D) durch ein das Arbeitsverhalten der ersten Stromerzeugungseinrichtung beschreibendes entsprechendes mathematisches Modell.

3. Verfahren nach einem oder mehreren der vorhergehenden Ansprüche, **dadurch gekennzeichnet, dass** der zweite Beobachtungswert ($EPC_{OF}$) berechnet wird auf Basis eines oder mehrerer dritter Beobachtungswerte ($EPC_{OD'}$), die die Stromproduktion von zweiten Stromerzeugungseinrichtungen (D') anzeigen, die zu der Familie ($F_D$) von Stromerzeugungseinrichtungen zählen einschließlich der ersten Stromerzeugungseinrichtung (D), während der Beobachtungszeitperiode (To), wobei jeder dritte Beobachtungswert ($EPC_{OD'}$) berechnet wird auf Basis der zweiten Daten ($DATA_2$).

4. Verfahren nach Anspruch 3, **dadurch gekennzeichnet, dass** der zweite Beobachtungswert ($EPC_{OD'}$) berechnet wird auf Basis von zweiten Modellierungsdaten ($K_2$) erhalten durch Modellieren des Arbeitsverhaltens der ersten Stromerzeugungseinrichtung (D) und jeder zweiten Stromerzeugungseinrichtung (D'), in der Familie ($F_D$) von Stromerzeugungseinrichtungen enthalten, durch das Arbeitsverhalten der ersten und zweiten Stromerzeugungseinrichtungen (D, D') beschreibende entsprechende mathematische Modelle.

5. Verfahren nach einem oder mehreren der vorhergehenden Ansprüche, **dadurch gekennzeichnet, dass** es einen Schritt des Erfassens (104) dritter Daten ($DATA_3$) umfasst, die die Installationsbedingungen der ersten Stromerzeugungseinrichtungen (D) anzeigen.

6. Verfahren nach Anspruch 5, **dadurch gekennzeichnet, dass** der Schritt (108) des Berechnens des ersten erwarteten Stromproduktionswerts ($EPC(t_{Fore})$) das Berechnen eines ersten Korrekturfaktors ($L_D$) zum Korrigieren des zweiten Beobachtungswerts ($EPC_{OF}$) umfasst, wobei der erste Korrekturfaktor den Einfluss der Installationsbedingungen der ersten Stromerzeugungseinrichtung (D) auf die Stromerzeugung der ersten Stromerzeugungseinrichtung anzeigt, wobei die Berechnung des ersten erwarteten Stromproduktionswerts auf dem ersten Korrekturfaktor basiert.

7. Verfahren nach Anspruch 6, **dadurch gekennzeichnet, dass** der erste Korrekturfaktor ($L_D$) berechnet wird auf Basis von Installationsparametern ($D_y$), in den dritten Daten ($DATA_3$) enthalten, und gewählt für die erste Stromerzeugungseinrichtung (D) und basierend auf dritten Modellierungsdaten (a) erhalten durch Modellieren des Arbeitsverhaltens der ersten Stromerzeugungseinrichtung (D) unter Verwendung eines das Arbeitsverhalten der ersten Stromerzeugungseinrichtung beschreibenden entsprechenden mathematischen Modells.

8. Verfahren nach einem oder mehreren der vorhergehenden Ansprüche, **dadurch gekennzeichnet, dass** es den Schritt des Erfassens (105) vierter Daten ($DATA_4$), die eine geografische Position der ersten Stromerzeugungseinrichtungen (D) und der zweiten Stromerzeugungseinrichtungen (D') anzeigen, umfasst.

9. Verfahren nach Anspruch 8, **dadurch gekennzeichnet, dass** der Schritt (108) des Berechnens des ersten erwarteten Stromerzeugungswerts ($EPC(t_{Fore})$) das Berechnen eines Normalisierungsfaktors ($N_D$) für den zweiten Beobachtungswert ($EPC_{OF}$) umfasst, wobei die Berechnung des ersten erwarteten Stromerzeugungswerts auf dem Normalisierungsfaktor basiert.

10. Verfahren nach Anspruch 3 und 9, **dadurch gekennzeichnet, dass** die Berechnung des Normalisierungsfaktors ($N_D$) umfasst:

    - Berechnen eines Ähnlichkeitskoeffizienten ($S_D$), der die Ähnlichkeit anzeigend zwischen dem Arbeitsverhalten der ersten Stromerzeugungseinrichtung (D) und dem Arbeitsverhalten einer gewählten zweiten Stromerzeugungseinrichtung (D'), die zu der Familie ($F_D$) der Stromerzeugungseinrichtungen einschließlich der ersten Stromerzeugungseinrichtung (D) gehört, wobei der Ähnlichkeitskoeffizient berechnet wird auf Basis des für die erste Stromerzeugungseinrichtung (D) berechneten ersten Beobachtungswerts ($EPC_{O,D}$) und des für die gewählte zweite Stromerzeugungseinrichtung (D') berechneten dritten Beobachtungswerts ($EPC_{OD'}$);
    - Berechnen eines Geolokalisierungskoeffizienten ($S_D$), der die Differenz zwischen der geografischen Position der ersten Stromerzeugungseinrichtung (D) und der geografischen Position der gewählten zweiten Stromerzeugungseinrichtung (D') anzeigt, wobei der Geolokalisierungskoeffizient berechnet wird auf Basis der vierten Daten ($DATA_4$);

    wobei die Berechnung des Normalisierungsfaktors auf dem Ähnlichkeitskoeffizienten und dem Geolokalisierungskoeffizienten basiert.

11. Verfahren nach einem oder mehreren der vorhergehenden Ansprüche, **dadurch gekennzeichnet, dass** es den Schritt des Erfassens (110) fünfter Daten ($DATA_5$) umfasst, die meteorologische Bedingungen an der Anlage (I) zur Erzeugung erneuerbarer Energie zu einem oder mehreren Zeitpunkten der Beobachtungsperiode (To) anzeigt.

12. Verfahren nach Anspruch 11, **dadurch gekennzeichnet, dass** es einen Schritt (111) des Berechnens eines Konfidenzindexes (CF) umfasst, der einen Genauigkeitsgrad der Berechnung des zweiten erwarteten Stromerzeugungswerts ($EPC_I(t_{Fore})$) anzeigt, wobei der Konfidenzindex berechnet wird auf Basis der fünften Daten ($DATA_5$).

13. Verfahren nach Anspruch 12, **dadurch gekennzeichnet, dass** der Schritt (111) des Berechnens des Konfidenzindexes (CF) umfasst:

    - Wählen (111A) eines in der Beobachtungsperiode (To) enthaltenen optimalen Zeitpunkts ($t_{Past}$), in dem meteorologische Bedingungen an der Stromerzeugungsanlage (I) optimal waren;
    - Berechnen (111B) eines optimalen Stromerzeugungswerts (IPC), der die Stromerzeugung der Stromerzeugungsanlage (I) zu dem optimalen Zeitpunkt ($t_{Past}$) anzeigt;
    - Berechnen (111C) einer oder mehrerer vergangener Stromerzeugungswerte ($EPC_{Old}$) zu einem oder mehreren in der Beobachtungsperiode (To) enthaltenen und von dem optimalen Zeitpunkt ($t_{Past}$) verschiedenen Zeitpunkten,
    - Vergleichen (111D) jedes vergangenen Stromerzeugungswerts ($EPC_{Old}$) mit dem optimalen Stromerzeugungswert (IPC);
    - Berechnen (111E) einer oder mehrerer Differenzindizes ($\Delta Ci$), die eine Differenz zwischen vergangenen Stromerzeugungswerten ($EPC_{Old}$) und dem optimalen Stromerzeugungswert (IPC) anzeigen;
    - Berechnen (111F) des Konfidenzindexes (CF) auf Basis der Differenzindizes ($\Delta Ci$).

14. Verfahren nach einem oder mehreren der vorhergehenden Ansprüche, **dadurch gekennzeichnet, dass** es den Schritt des Erfassens (112) sechster Daten ($DATA_6$) umfasst, die eine oder mehrere in der Anlage (I) zur Erzeugung erneuerbarer Energie gemessene physikalische Größen zu dem Referenzzeitpunkt ($t_{now}$) anzeigt.

15. Verfahren nach Anspruch 14, **dadurch gekennzeichnet, dass** es einen Schritt (113) des Berechnens eines dritten erwarteten Stromerzeugungswerts ($EPC_{RT}(t_{Fore})$) umfasst, der die erwartete Stromerzeugung der Stromerzeugungsanlage (I) zu dem zukünftigen Zeitpunkt ($t_{Fore}$) anzeigt, wobei der dritte erwartete Stromerzeugungswert berechnet wird auf Basis des zweiten erwarteten Stromerzeugungswerts ($EPC_I(t_{Fore})$) und der sechsten Daten ($DATA_6$).

**16.** Verfahren nach Anspruch 15, **dadurch gekennzeichnet, dass** der Schritt (113) des Berechnens des dritten erwarteten Stromerzeugungswerts ($EPC_{RT}(t_{Fore})$) das Berechnen eines zweiten Korrekturfaktors ($R_T$) zum Korrigieren des zweiten erwarteten Stromerzeugungswerts auf Basis der sechsten Daten ($DATA_6$) umfasst.

**17.** Verfahren nach einem oder mehreren der vorhergehenden Ansprüche, **dadurch gekennzeichnet, dass** die Anlage (I) zur Erzeugung erneuerbarer Energie eine photovoltaische Stromerzeugungsanlage ist.

**18.** Computerisiertes System umfassend Datenverarbeitungsressourcen konfiguriert zum Ausführen eines Verfahrens (100) nach einem oder mehreren der vorhergehenden Ansprüche.

**Revendications**

**1.** Procédé (100) de prévision de la production d'électricité d'une centrale de génération d'énergie renouvelable (I), ladite centrale de génération d'énergie comportant un ou plusieurs premiers dispositifs de génération d'énergie (D) pouvant générer de l'énergie électrique en exploitant une source d'énergie renouvelable, le procédé comprenant les étapes suivantes :

- la sélection (101) d'un instant de référence ($t_{Now}$) et d'une période d'observation (To) incluant des instants précédant ledit instant de référence ($t_{Now}$),
- l'acquisition (102) de premières données ($DATA_1$) indicatives de la production d'énergie électrique desdits premiers dispositifs de génération d'énergie (D) pendant ladite période d'observation (To),
- l'acquisition (103) de deuxièmes données ($DATA_2$) indicatives de la production d'énergie électrique d'un ou plusieurs seconds dispositifs de génération d'énergie (D') pendant ladite période d'observation (To), lesdits seconds dispositifs de génération d'énergie (D') pouvant générer de l'énergie électrique en exploitant une source d'énergie renouvelable et en étant installés dans une ou plusieurs centrales de génération d'énergie renouvelable différentes de ladite centrale de génération d'énergie renouvelable (I),
- pour chaque premier dispositif de génération d'énergie (D), le calcul (106) d'une première valeur d'observation ($EPC_{OD}$) indicative de la production d'énergie électrique dudit premier dispositif de génération d'énergie (D) à ladite période d'observation (To), ladite première valeur d'observation ($EPC_{OD}$) étant calculée sur la base desdites premières données ($DATA_1$), **caractérisé en ce que** le procédé comprend les étapes suivantes :
- pour chaque premier dispositif de génération d'énergie (D), le calcul (107) d'une deuxième valeur d'observation ($EPC_{OF}$) indicative de la production d'énergie électrique d'une famille ($F_D$) de dispositifs de génération d'énergie qui inclut ledit premier dispositif de génération d'énergie (D) et un ou plusieurs seconds dispositifs de génération d'énergie (D') présentant la même structure et le même fonctionnement que ledit premier dispositif de génération d'énergie (D), pendant ladite période d'observation ($T_O$), ladite deuxième valeur d'observation étant calculée sur la base de ladite première valeur d'observation ($EPC_{OD}$) et desdites deuxièmes données ($DATA_2$),
- pour chaque premier dispositif de génération d'énergie (D), le calcul (108) d'une première valeur de production d'énergie électrique attendue ($EPC(t_{Fore})$) indicative de la production d'énergie électrique attendue dudit premier dispositif de génération d'énergie (D) à un instant futur ($t_{Fore}$) qui suit ledit instant de référence ($t_{Now}$), ladite première valeur de production d'énergie électrique attendue ($EPC(t_{Fore})$) étant calculée sur la base de ladite deuxième valeur d'observation ($EPC_{OF}$),
- le calcul (109) d'une deuxième valeur de production d'énergie électrique attendue ($EPC_I(t_{Fore})$) indicative de la production d'énergie électrique attendue de ladite centrale de génération d'énergie (I) au dit instant futur ($t_{Fore}$), ladite deuxième valeur de production d'énergie électrique attendue étant calculée sur la base de la première valeur de production d'énergie électrique attendue ($EPC(t_{Fore})$) calculée pour les premiers dispositifs de génération d'énergie (D) installés dans ladite centrale d'énergie renouvelable (I).

**2.** Procédé selon la revendication 1, **caractérisé en ce que** ladite première valeur d'observation ($EPC_{OD}$) est calculée sur la base de premières données de modélisation ($K_1$) obtenues en modélisant le comportement fonctionnel dudit premier dispositif de génération d'énergie (D) par l'intermédiaire d'un modèle mathématique correspondant qui décrit le comportement fonctionnel dudit premier dispositif de génération d'énergie.

3. Procédé selon une ou plusieurs des revendications précédentes, **caractérisé en ce que** ladite deuxième valeur d'observation ($EPC_{OF}$) est calculée sur la base d'une ou plusieurs troisièmes valeurs d'observation ($EPC_{OD'}$) indicatives de la production d'énergie électrique de seconds dispositifs de génération d'énergie (D') qui appartiennent à la famille ($F_D$) de dispositifs de génération d'énergie incluant ledit premier dispositif de génération d'énergie (D) pendant ladite période d'observation (To), chaque troisième valeur d'observation ($EPC_{OD'}$) étant calculée sur la bases desdites deuxièmes données ($DATA_2$).

4. Procédé selon la revendication 3, **caractérisé en ce que** ladite deuxième valeur d'observation ($EPC_{OD'}$) est calculée sur la base de secondes données de modélisation ($K_2$) obtenues en modélisant le comportement fonctionnel dudit premier dispositif de génération d'énergie (D) et de chacun des deuxièmes dispositifs de génération d'énergie (D') inclus dans ladite famille ($F_D$) de dispositifs de génération d'énergie par l'intermédiaire de modèles mathématiques correspondants qui décrivent le comportement fonctionnel desdits premier et deuxièmes dispositifs de génération d'énergie (D, D').

5. Procédé selon une ou plusieurs des revendications précédentes, **caractérisé en ce qu'**il comprend une étape d'acquisition (104) de troisièmes données ($DATA_3$) indicatives des conditions d'installation desdits premiers dispositifs de génération d'énergie (D).

6. Procédé selon la revendication 5, **caractérisé en ce que** ladite étape (108) de calcul de ladite première valeur de production d'énergie électrique attendue ($EPC(t_{Fore})$) comprend le calcul d'un premier facteur de correction ($L_D$) destiné à corriger ladite deuxième valeur d'observation ($EPC_{OF}$), ledit facteur de correction étant indicatif de l'influence des conditions d'installation dudit premier dispositif de génération d'énergie (D) sur la production d'énergie électrique dudit premier dispositif de génération d'énergie, le calcul de ladite première valeur de production d'énergie électrique attendue étant fondé sur ledit premier facteur de correction.

7. Procédé selon la revendication 6, **caractérisé en ce que** ledit premier facteur de correction ($L_D$) est calculé sur la base de paramètres d'installation ($D_y$) inclus dans lesdites troisièmes données ($DATA_3$), et sélectionné pour ledit premier dispositif de génération d'énergie (D), et, sur la base de troisièmes données de modélisation ($a$), obtenu en modélisant le comportement fonctionnel dudit premier dispositif de génération d'énergie (D) en utilisant un modèle mathématique correspondant décrivant le comportement fonctionnel dudit premier dispositif de génération d'énergie.

8. Procédé selon une ou plusieurs des revendications précédentes, **caractérisé en ce qu'**il comprend l'étape d'acquisition (105) de quatrièmes données ($DATA_4$) indicatives de la position géographique desdits premiers dispositifs de génération d'énergie (D) et desdits seconds dispositifs de génération d'énergie (D').

9. Procédé selon la revendication 8, **caractérisé en ce que** ladite étape (108) de calcul de ladite première valeur de production d'énergie électrique attendue ($EPC(t_{Fore})$) comprend le calcul d'un facteur de normalisation ($N_D$) pour ladite deuxième valeur d'observation ($EPC_{OF}$), le calcul de ladite première valeur de production d'énergie électrique attendue étant fondé sur ledit facteur de normalisation.

10. Procédé selon la revendication 3 et la revendication 9, **caractérisé en ce que** ledit calcul dudit facteur de normalisation ($N_D$) comprend :

    - le calcul d'un coefficient de similarité ($S_D$) indicatif de la similarité entre le comportement fonctionnel dudit premier dispositif de génération d'énergie (D) et le comportement fonctionnel d'un second dispositif de génération d'énergie (D') sélectionné appartenant à la famille ($F_D$) de dispositifs de génération d'énergie incluant ledit premier dispositif de génération d'énergie (D), ledit coefficient de similarité étant calculé sur la base de la première valeur d'observation ($EPC_{OD}$) pour ledit premier dispositif de génération d'énergie (D) et de la troisième valeur d'observation ($EPC_{OD'}$) calculée pour ledit second dispositif de génération d'énergie (D') sélectionné,
    - le calcul d'un coefficient de géolocalisation ($S_D$) indicatif de la différence existant entre la position géographique dudit premier dispositif de génération d'énergie (D) et la position géographique dudit second dispositif de génération d'énergie (D') sélectionné, ledit coefficient de géolocalisation étant calculé sur la base desdites quatrièmes données ($DATA_4$),

    le calcul dudit facteur de normalisation étant fondé sur ledit coefficient de similarité et ledit coefficient de géolocalisation.

11. Procédé selon une ou plusieurs des revendications précédentes, **caractérisé en ce qu'**il comprend l'étape d'acquisition (110) de cinquièmes données (DATA$_5$) indicatives des conditions météorologiques au niveau de ladite centrale de génération d'énergie renouvelable (I) à un ou plusieurs instants de ladite période d'observation (To).

**12.** Procédé selon la revendication 11, **caractérisé en ce qu'**il comprend l'étape (111) de calcul d'un indice de confiance (CF) indicatif du niveau de précision du calcul de ladite deuxième valeur de production d'énergie électrique attendue (EPC$_I$(t$_{Fore}$)), ledit indice de confiance étant calculé sur la base desdites cinquièmes données (DATA$_5$).

**13.** Procédé selon la revendication 12, **caractérisé en ce que** ladite étape (111) de calcul dudit indice de confiance (CF) comprend :

- la sélection (111A) d'un instant optimal (t$_{Past}$) inclus dans ladite période d'observation (To) pour lequel les conditions météorologiques au niveau de ladite centrale de génération d'énergie (I) étaient optimales,
- le calcul (111B) d'une valeur optimale de production d'énergie électrique (IPC) indicative de la production d'énergie électrique de ladite centrale de génération d'énergie (I) au dit instant optimal (t$_{Past}$),
- le calcul (111C) d'une ou plusieurs valeurs passées de production d'électricité (EPC$_{Old}$) à un ou plusieurs instants inclus dans ladite période d'observation (To) et différents dudit instant optimal(t$_{Past}$),
- la comparaison (111D) de chaque valeur passée de production d'électricité (EPC$_{Old}$) à ladite valeur optimale de production d'énergie électrique (IPC),
- le calcul (111E) d'un ou plusieurs indices différentiels ($\Delta C_i$) indicatifs d'une différence existant entre lesdites valeurs passées de production d'électricité (EPC$_{Old}$) et ladite valeur optimale de production d'énergie électrique (IPC),
- le calcul (111F) dudit indice de confiance (CF) en se fondant sur lesdits indices différentiels ($\Delta C_i$).

**14.** Procédé selon une ou plusieurs des revendications précédentes, **caractérisé en ce qu'**il comprend l'étape d'acquisition (112) de sixièmes données (DATA$_6$) indicatives d'une ou plusieurs quantités physiques mesurées dans ladite centrale de génération d'énergie renouvelable (I) au dit instant de référence (t$_{Now}$).

**15.** Procédé selon la revendication 14, **caractérisé en ce qu'**il comprend une étape (113) de calcul d'une troisième valeur de production d'énergie électrique attendue (EPC$_{RT}$(t$_{Fore}$)) indicative de la production d'énergie électrique attendue de ladite centrale de génération d'énergie (I) au dit instant futur (t$_{Fore}$), ladite troisième valeur de production d'énergie électrique attendue étant calculée sur la base de ladite deuxième valeur de production d'énergie électrique attendue (EPC$_I$(t$_{Fore}$)) et desdites sixièmes données (DATA$_6$).

**16.** Procédé selon la revendication 15, **caractérisé en ce que** l'étape (113) de calcul de ladite troisième valeur de production d'énergie électrique attendue (EPC$_{RT}$(T$_{Fore}$)) comprend le calcul d'un second facteur de correction (R$_T$) destiné à corriger ladite deuxième valeur de production d'énergie électrique attendue sur la bases desdites sixièmes données (DATA$_6$).

**17.** Procédé selon une ou plusieurs des revendications précédentes, **caractérisé en ce que** ladite centrale de génération d'énergie renouvelable (I) est une centrale de génération d'énergie photovoltaïque.

**18.** Système informatisé comprenant des ressources de traitement de données configurées pour exécuter un procédé (100) conforme à une ou plusieurs des revendications précédentes.

EP 3 648 283 B1

**FIG. 1**

FIG. 2

100

| $t_{Now}$ , $T_O$ |
| 101 |
| 102 | DATA$_1$ |
| 103 | DATA$_2$ |
| 104 | DATA$_3$ |
| 105 | DATA$_4$ |
| 106 | EPC$_{OD}$ |
| continue |

FIG. 3

continue

107 ┄┄> EPC$_{OF}$

108 ┄┄> EPC(t$_{Fore}$)

100

109 ┄┄> EPC$_I$(t$_{Fore}$)

DATA$_5$ ┄┄> 110

DATA$_6$ ┄┄> 112

111 ┄┄> CF

113 ┄┄> EPC$_{RT}$(t$_{Fore}$)

**FIG. 4**

FIG. 5

FIG. 6

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 8295989 B1
- US 8165812 B1
- EP 1660917 B1
- WO 301130015851 A1
- US 2013046492 A1